(19) 

**Europäisches Patentamt**
**European Patent Office**
**Office européen des brevets**

(11) **EP 1 916 768 A1**

(12) **EUROPEAN PATENT APPLICATION**

(43) Date of publication:
**30.04.2008 Bulletin 2008/18**

(51) Int Cl.:
***H03L 7/00*** *(2006.01)*

(21) Application number: **07106731.8**

(22) Date of filing: **23.04.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **27.10.2006 US 863174 P**

(71) Applicants:
• **INTERUNIVERSITAIR MICRO-ELEKTRONICA CENTRUM VZW**
**3001 Leuven (BE)**

• **Stichting IMEC Nederland**
**5656 AZ Eindhoven (NL)**

(72) Inventors:
• **Ryckaert, Julien**
**B-3080, Tervuren (Vossem) (BE)**
• **Craninckx, Jan**
**B-3370, Boutersem (BE)**

(74) Representative: **Sarlet, Steven Renaat Irène et al**
**Gevers & Vander Haeghen,**
**Holidaystraat, 5**
**1831 Diegem (BE)**

(54) **Device and method for generating a signal with predefined transient at start-up**

(57) A device and a method are presented for generating a signal at least part of which is an oscillation signal with a characterising frequency and with a predefined transient at start-up, suited for communication systems, in particular for Ultra-Wide Bandwidth (UWB) applications. The device comprises a variable oscillator for generating said oscillation signal and has a means for setting initial conditions in said variable oscillator, to impose said predefined transient on said oscillation signal at start-up. The method for generating the output signal comprises the steps of: a) providing initial conditions which determine said predefined transient in initial condition setting means; b) imposing said initial conditions on a variable oscillator; and c) starting said variable oscillator to generate said oscillation signal.

Figure 2

## Description

### Field of invention

The present invention relates to a device and a method for generating a signal at least part of which is an oscillation signal with a characterising frequency and with a predefined transient at start-up, suited for communication systems, in particular for Ultra-Wide Bandwidth (UWB) applications.

### Background art

Devices which are designed to generate signals with a controlled frequency are commonly used in a variety of applications. Typical examples are radio transmitters, transmitters and receivers in telecommunications, computer devices and other electronic applications where it is desired to stabilize a generated signal or to detect signals in the presence of noise.

Traditionally, the controlled frequency is implemented by a phase locked loop (PLL). This is a closed-loop feedback control system that generates and outputs a signal in relation to the frequency and phase of a reference signal. The PLL comprises of a phase detector, a variable oscillator, and a feedback loop. The circuit reacts to both the frequency and the phase, automatically raising or lowering the frequency of the variable oscillator until there is a match with both the frequency and the phase of the reference signal.

A disadvantage of this technique is the large start-up time for both phase and frequency compensation, demanding significant power. This is not well suited for many battery-operated, portable and hand held device applications. A second drawback of this approach is the accumulative jitter process typically initiated by the voltage controlled oscillator (VCO) (in series with jittery circuitry).

Another idea is presented in European Publication EP-A 0601780. A technique is described for a programmable frequency generator. The frequency is established in a ring oscillator. This is done by a set of transistors who give an operating current for the ring. The device can be turned off to reduce the power supply. The tuning in phase and frequency is solely done by adapting the frequency. This approach results in a reduced accuracy and slows down the process.

### Aim of the invention

It is an aim of the invention to provide a device and a method for generating a signal with a characterising frequency in a very fast, accurate way consuming little power.

This aim is achieved according to the invention with the device and method of the independent claims.

## Summary of the invention

According to the invention, a device is presented for generating an output signal at least part of which is an oscillation signal with a characterising frequency and with a predefined transient at start-up. The device comprises a variable oscillator, preferably a digitally controlled oscillator, for generating the oscillation signal. The predefined transient at start-up is ensured by imposing initial settings on the variable oscillator. As a consequence, the phase of the generated signal will be uniform at start-up and only the frequency needs to be adapted. The output signal with a controlled frequency can be generated very fast and accurate. Therefore, the activity mode of the device can be reduced and, as a consequence, also the power consumption. The device combines also the advantages of no jitter and scalability.

In a preferred embodiment, the device further comprises a feedback means for controlling the frequency of the oscillation signal. In an embodiment the feedback means comprises a detection means, which compares the characterising frequency to that of a reference and inputs a result indicative of this comparison into a storage means associated with the variable oscillator. Dependent on this result, the frequency of the generated output signal is adapted. Only the frequency and not the phase of the generated signal needs to be adapted. This action is performed very fast and accurate.

In another embodiment of the present invention, the device further comprises a dividing means for dividing the frequency of the generated output signal at least once to a signal with a frequency roughly matching a preset frequency. The frequency may be divided twice. The frequency is preferably divided by an integer value to produce the preferred chip rate and maybe further by a fixed value. In this embodiment, the detection means is provided for comparing the divided frequency to that of a reference and for inputting a result indicative of this comparison into a storage means associated with the variable oscillator.

In a preferred embodiment, the variable oscillator comprises at least two stages with the initial setting means being connected to nodes in between the stages. Further, the nodes may be voltage nodes and the initial setting means may comprise switches between ground and supply voltage on those voltage nodes. Fast and uniform start-up is achieved by setting the nodes at a predefined state.

In an embodiment, the device can produce an RF carrier. In another embodiment, the device may further comprise a modulator producing preferably a BPSK modulated signal on the basis of said output signal.

The device of the invention can for example be incorporated in a telecom device, such as for example a transmitter, a receiver, a transceiver, an Ultra-Wide Bandwidth telecom device or any other telecom device known to the person skilled in the art.

Further according to the present invention a method is presented for generating an output signal, at least part of which is an oscillation signal with a predefined transient at start-up. The above mentioned advantages also apply to this method. The method comprising the steps of: a) providing initial conditions determining said predefined transient in initial condition setting means; b) imposing said initial conditions on a variable oscillator; and c) starting said variable oscillator to generate said oscillation signal. This method can generate very fast an accurate signal. Again, the activity mode of the device can be reduced and, as a consequence, also the power consumption. It combines also the advantages of no jitter and scalability.

The method preferably also comprises the step of reading out a stored characterising frequency simultaneously with step b. This frequency can be proposed at start-up to have an indication of the preferred frequency of the generated signal.

Further, the method preferably comprises the step of controlling the frequency of the oscillation signal by means of a feedback means. In a preferred embodiment, this step of controlling comprises the step of comparing the frequency of the generated output signal to that of a reference and inputting a result indicative of this comparison into a storage means associated with the variable oscillator.

In another embodiment of the present invention, the method further comprises the step of dividing the frequency of the output signal at least once to a signal with a frequency roughly matching a preset frequency. The frequency is preferably divided by an integer value to produce the preferred chip rate and may be further divided by a fixed value.

The step of imposing initial conditions on nodes in between cascaded stages of the variable oscillator preferably comprises the step of switching the nodes to either ground or supply voltage.

In an alternative embodiment of the present invention, the method comprises the step of modulating the generated output signal to a BPSK modulated signal.

A method for low power operation of a telecom device is characterised by the following steps: a) powering-on before mentioned telecom device, b) providing initial conditions determining a predefined transient at start-up, c) imposing those initial conditions on a variable oscillator, d) powering-down the telecom device and e) storing a latest frequency of the generated output signal.

In alternative embodiments, the low power operation can be performed by a transmitter, a receiver, a transceiver, an Ultra-Wide bandwidth telecom device...

By using this device according to the described method, the activity mode of the device can be reduced and as a consequence, also the power consumption.

## Brief description of the drawings

Presently preferred embodiments are described below in conjunction with the appended drawing figures, wherein like reference numerals refer to like elements in the various figures, and wherein:

Fig. 1 shows a block diagram of the present invention.

Fig. 2 shows a more detailed block diagram of the present invention.

Fig. 3 shows a circuit diagram of a DCO.

Fig. 4 shows a circuit diagram of a half transparent latch.

Fig. 5 shows a circuit diagram of a programmable divider.

Fig. 6 shows a circuit diagram of a pre-charge circuit and a graph of a reaction of the pre-charge circuit.

Fig. 7 shows a circuit diagram of an early-late detector circuit and a timing chart of typical signals.

Fig. 8 shows a graph of a four-step inversion process.

Fig. 9 shows a circuit diagram of sampling instants for a division.

Fig. 10 shows a schematic of a modulator core.

Fig.11 shows a start-up sequence of a modulator, according to an example.

Fig.12 shows a graph of a burst output of the modulator, according to an example.

## Detailed description of the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

The following detailed description relates to a device for generating an output signal at least part of which is an oscillation signal with a characterising frequency and with a predefined transient at start-up. The device can be used to produce very fast a very accurate variable frequency system clock.

Large start-up time is reduced by using a so called phase-aligned frequency locked loop. The phase alignment is done by forcing a uniform start-up of the variable oscillator when switching the device on. For example, for Ultra-Wide Bandwidth (UWB) communications (range from 3 to 10GHz), the maximum settling time of the variable oscillator, preferably a digitally controlled oscillator (DCO), is below 2ns to achieve 4MHz accuracy (to keep the signal-to-noise (SNR) degradation below 1dB over the burst of the signal). Summarised, the tuning process takes less than 2ns and attains a 0,04% to 0,1% tolerance for signals with a frequency range going from 3 to 10GHz (compared with prior art: 150$\mu$s to attain 0,5% to 4% for signals between 400kHz to 100MHz).

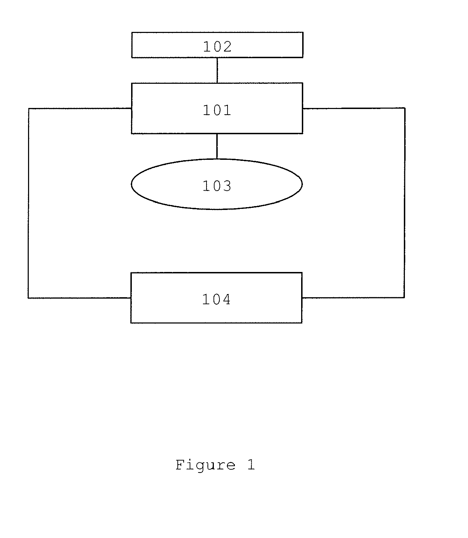

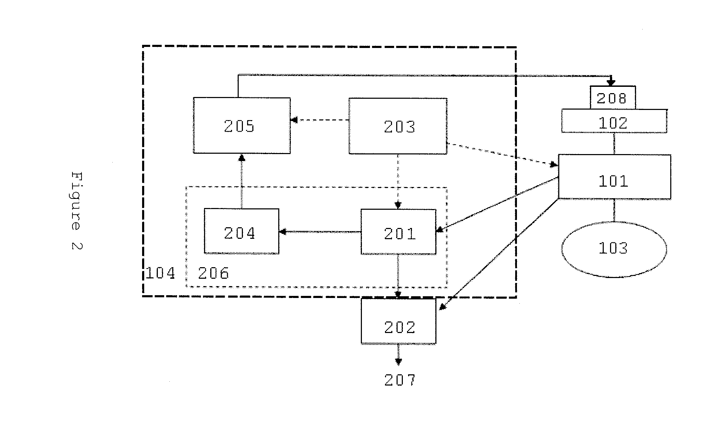

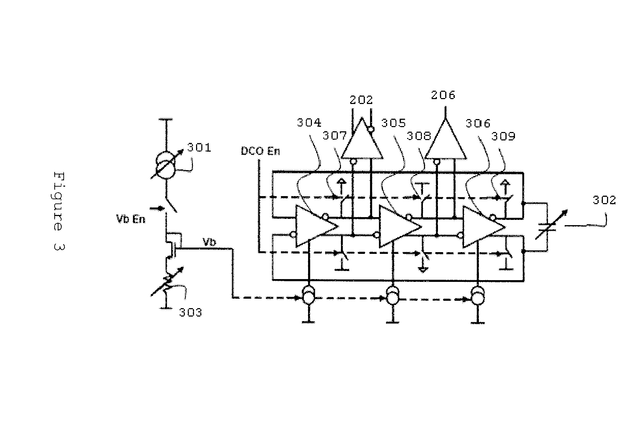

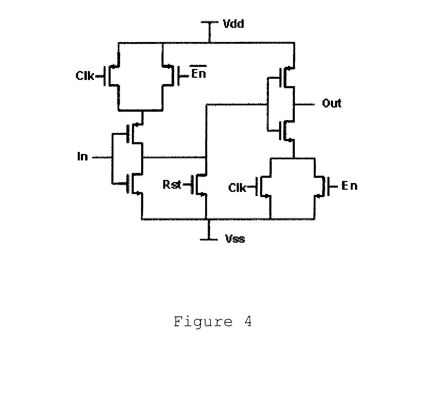

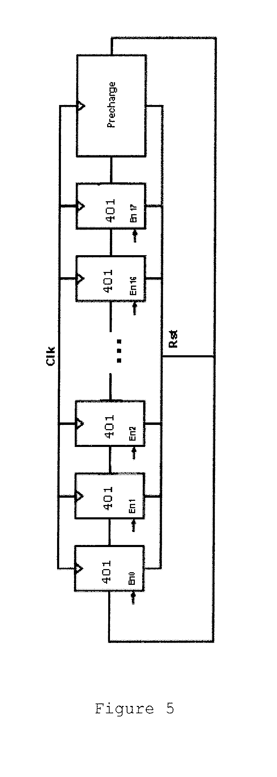

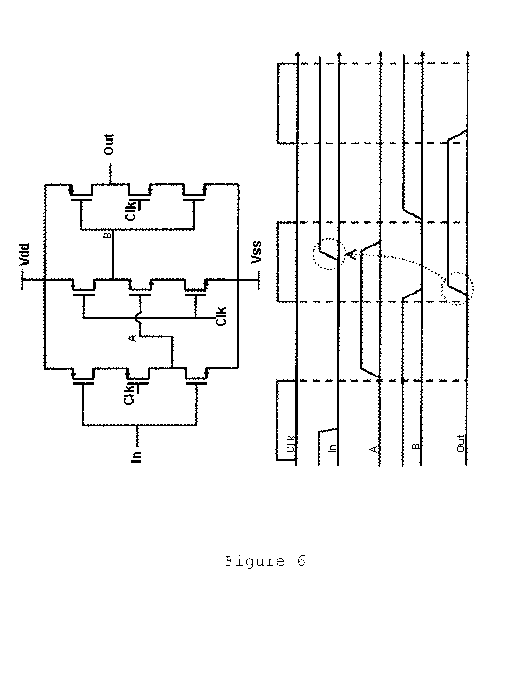

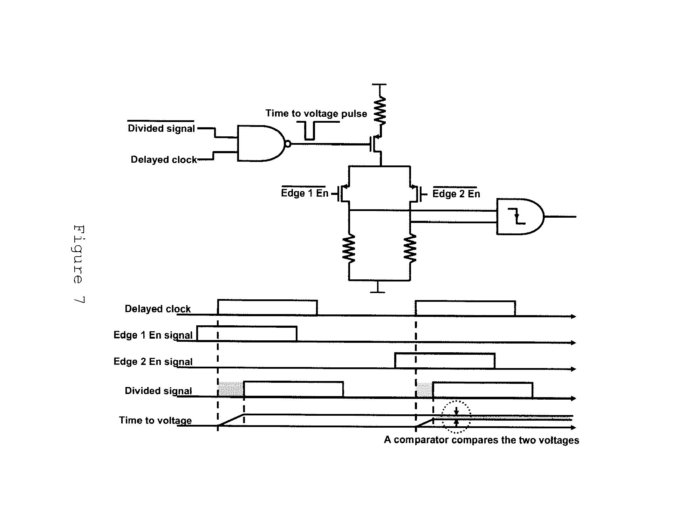

A schematic block diagram of a system using the present invention is shown in Fig.1. It comprises a variable oscillator (101) and a means for setting (103) initial conditions in order to impose a predefined transient at start-up. The variable oscillator is preferably a digitally controlled oscillator (DCO), but can be any oscillator known to the person skilled in the art, like for example a voltage controlled oscillator (VCO). The DCO (101) may further comprise a storage means (102). The frequency of the generated signal is controlled by a feedback means (104).

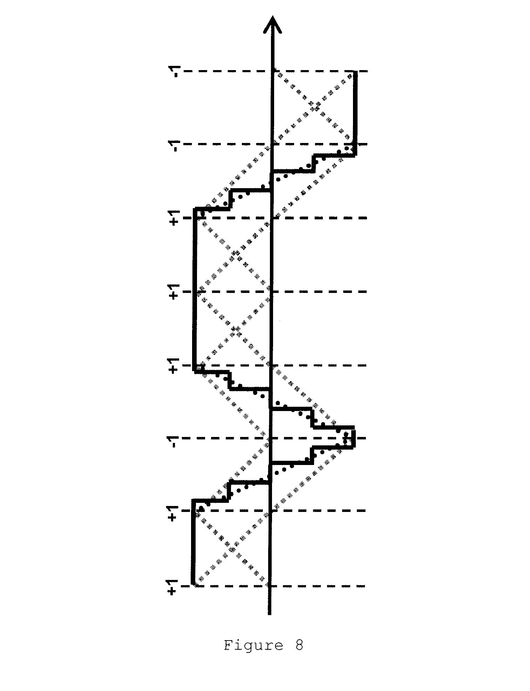

A more detailed block diagram of an example wherein the present invention is used, is shown in fig.2. The device of the present invention can be understood with reference to the next building blocks: a DCO (101) with storage (102) and a feedback loop (104) comprising a block with dividers (206) and a detection means (205). The inputs are provided by a signal generator (203) for programming some reference signals for the DCO (101) as well as the detection means (205) and also one of the dividers (201).

The device can be used for example as stand-alone integrated circuit chip. The device can produce an RF carrier for all bands between 3 and 10GHz. Additionally the output signal of the present invention can be modulated by a modulator, preferably a digital modulator (DMO) (202) to create for example Binary Phase-shift Keying (BPSK) (207) symbols at a certain rate (preferably the chip rate which equals to 499.2MHz). Any other modulation scheme known to the person skilled in the art can also be used (QPSK, ...).

The DCO can be for example a ring oscillator (RO) as sketched in fig.3. Such an oscillator may have three differential stages (304, 305, 306). It reaches high frequencies and has a very large tuning range with sufficient oscillation instability margin. The RO can cover a wide frequency range (for example for UWB from 3 to 10GHz).

The wide range together with a fine frequency accuracy specification requires the tuning to be done with three different methods. Implementing the full tuning range with a switchable biasing current would entail matching with large transistors for the smallest frequency steps whose capacitances would unbearably slow down the start-up of the circuit. Therefore, a 6-bit current source (301) is used only for coarse tuning, such as to benefit from its power scalability. The medium tuning, a 5-bit capacitor bank (302) is used since it does not degrade start-up time. However, the 5-bit capacitor bank is limited in the minimum frequency steps by parasitic capacitances. Therefore, the finest tuning is implemented with an 8-bit tuning (303) on the degeneration resistor of the biasing current mirror. A 4-bit binary has been used to ensure a monotonous frequency tuning curve.

In conclusion, although thirteen bits would ideally be sufficient to cover the full band, the necessary overlap (overlap between adjacent ones to ensure continuity in the frequency sweep) between the various frequency tunings lead to nineteen bits tuning. Summarized, three means of tuning have been used:

- A coarse tuning based on changing the bias current in the differential pairs;
- A medium tuning based on adding capacitances on the nodes; and
- A fine tuning based on changing the degeneration resistance of the DCO biasing current mirror in small steps.

As the divider (201) has a heavy input buffer, a cascade of inverters (304, 305, 306) has been implemented to drive the buffer. The capacitances bank is attached also to one of the differential node. Additional switches (307, 308, 309) at each of the outputs of the ring oscillator are placed alternatively versus ground and supply to impose an initial state when the ring is started. Fast and uniform start-up of the DCO (101) is achieved by setting the ring oscillator nodes at a predefined state and releasing them at a reference clock edge.

The frequency divider (201) divides the DCO frequency by an integer value from 7 to 20 to produce the chip rate. The fully dynamic divider is realized in True Single-Phase Clock (TSPC) logic based on J. Yuan and C. Svensson ("Fast CMOS nonbinary divider and counter", IEE Electronic Letters, Vol.29, Issue 13, p. 1222-1223, June 1993), which is hereby incorporated by reference in its entirety. The divider comprises of a cascade of 18 half-transparent latches (401) (a latch is presented in fig. 4) in a loop closed by a pre-charge unit and clocked by the high frequency signal to be divided.

A circuit diagram of such a latch is shown in Figure 5. The divider (201) must divide the RF frequency by an integer value ranging from seven (for the 7*499.2MHZ RF LO) to twenty (for the 20*499.2MHz LO). The output of the divider should be 499.2MHz (=chip rate).

The circuit is in its transparent state when In = Out = 1 and the intermediate node to 0. Indeed, for a rising edge transition at the input, the circuit appears just as a cascade of two inverters. At a falling edge, the intermediate node changes state only when Clk is low and the value is stored since the second stage inverter has its pull down path open. When clock changes to value one, the pull down of the second stage is released and the transition is passed to the output. The En (Enable) input converts the circuit to a fully transparent cascade of two inverters such as to disable the latching operation. A reset (Rst) input is added to force the intermediate node back to the transparent state. Using this simple structure, a programmable divider can be realized, see Fig. 5.

Assuming that all of the latches are enabled and are set to their transparent states, a falling edge at the pre-charge circuit output will transit from an HT latch to the following at every cycle of the clock. It will thereby arrive at the pre-charge circuit input after eighteen clock cycles. The pre-charge circuit then resets all the latches back to the transparent state and creates a new falling edge. This last operation takes two clock cycles. Thereby, a cycle of the system corresponds in total to twenty clock cycles and the system acts as a divider by 20. If an HT latch is disabled, the HT latch passes the falling edge directly and the divider divides by 19. Division values of twenty down to seven can then be obtained by disabling the necessary number of latches. A circuit diagram of the pre-charge circuit is shown on Figure 6. A plot describing the principle is also shown. The rising edge is transparent to all latches and propagates back to the input.

Preferably, the detection means (205) comprises an early-late detector. The early-late detector (Fig.7) measures the time difference between the rising edge of the RF LO divided output and the reference clock. The difference between two consecutive measurements produces a 1-bit value specifying whether the RF LO is too high or too low. This result is then used to update the DCO frequency setting for example by a controller (208) associated with the DCO. Three binary search calibration steps are done to set respectively the coarse, the medium, and the fine tuning word, after which the DCO frequency is less than 4MHz of the desired frequency. Drift of the DCO frequency during operation is monitored by the ELD status after every transmitted burst, and the DCO control (208) is adjusted if necessary for the next burst.

The early-late detector compares the clock to a divided output of the DCO. The output is first divide by the high speed divider, than divided by a fixed value of 16. The block diagram of the early-late detector is shown on Figure 7.

The modulator (202) creates a burst by modulating the RF carrier. The burst consists of sixteen chips of 2.0243ns modulated in BPSK. The waveform of each chip is specified according to a cross-correlation rule. According to that definition, a triangular waveform of the chip duration can be used such that the modulator only needs to invert the carrier when the code transits from a- /+1 to a +/-1. The inverting operation is realized in discrete steps such as shown on Figure 8.

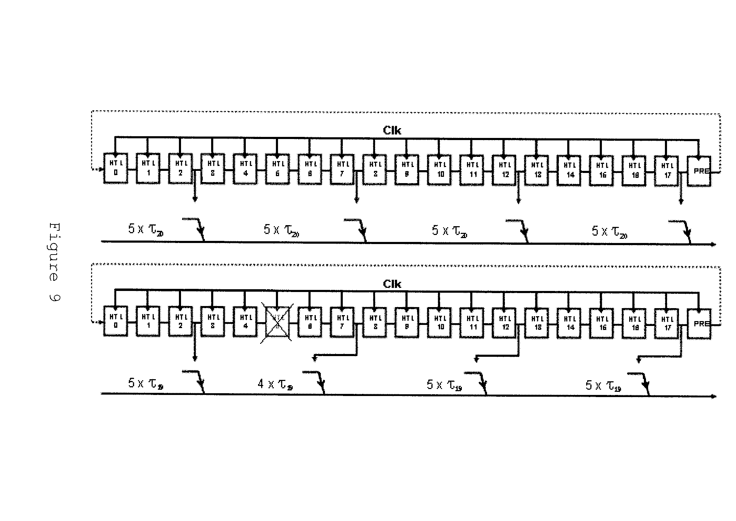

The sampling signals for the four steps are provided by the divider. The signal output of each of the HT latches is a 499.2MHz signal with a falling edge delayed either by 2.0243ns/N if the latch is enabled or by two inverter delays if the latch is fully transparent where N is the division value (seven-twenty). By taking four different appropriate outputs of the divider and by carefully choosing the disabled latches, four more or less regular falling edges can be obtained as sampling instants. This operation is shown in the diagram of Figure 9.

Figure 9 shows the example of a division by 20 as compared to a division by 19. In the divide by 20 example, the four time intervals defined by the four outputs are regularly spaced such that the duration of each segment is substantially 2.0243ns/4. If one latch is disabled for the division by 19, the segment of the disabled latch has a unit less than the other segments, resulting in three segments of regular spacing of 2.0243ns/19*5 and one segment of 2.0243ns/19*4. The same reasoning can be done for further division values.

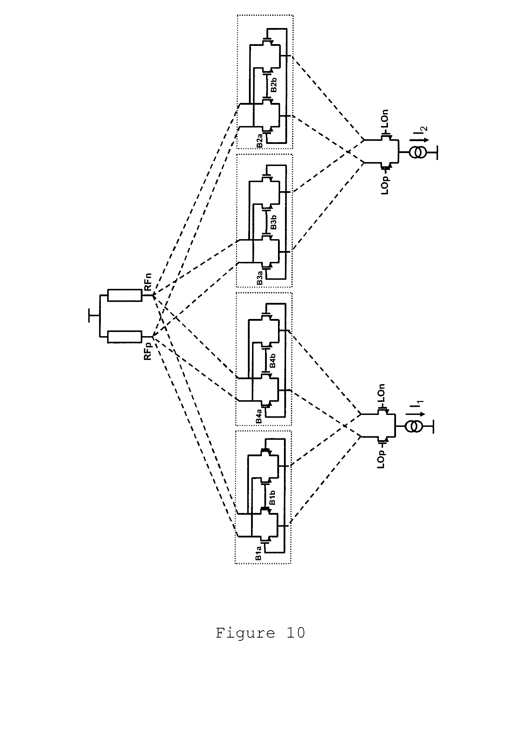

The modulator core itself is an extension of a gilbert-type multiplier. The schematic diagram of the modulator is shown in Figure 10. The tail of the modulator core is composed of two differential current sources where the current is modulated by the RF oscillator (Lop and LOn) and will provide the carrier of the signal. This current passes then through four units of cross-coupled switches that route the current to the positive load or the negative load depending on the value at the Bik inputs, where i=1:4 and k=a,b.

The circuit has three types of operations:

1. All Bik values are set to 0 and the structure is switched off;
2. All Bik values are set to 1 and the structure is switched on but no RF signal is present at the output; and
3. The Bia and Bib values are of opposite values and a differential RF current flows through the differential load.

In the case of the third operation, three different types of transitions can be achieved:

A. Transition from 0 to A and A to 0;
B. Transition from 0 to -A and -A to 0; and
C. Transition from A to -A and -A to A;

where A is the maximum signal amplitude. Transitions A and B are for the beginning and end of the burst sequence. Transition C is for the modulation by transitions itself. Transitions A and B are obtained from the state where all Bik values are set to 1 (type of operation number 2).

The units of cross-coupled switches are progressively switched on one by one from unit 1 to unit 4 to obtain the following transition:

$$\pm\frac{I_1}{2} \rightarrow \pm\left(\frac{I_1}{2}+\frac{I_2}{2}\right) \rightarrow \pm\left(\frac{I_1}{2}+I_2\right) \rightarrow \pm(I_1+I_2)$$

The transition follows either positive transitions or negative transitions depending on the first value in the code.

Transition C is achieved by inverting each of the units of cross-coupled switches one by one from unit 1 to unit 4 to obtain the following transitions:

$$\mp(I_1+I_2) \rightarrow \mp I_2 \rightarrow \pm I_2 \rightarrow \pm(I_1+I_2)$$

In this way, the transitions A and B are two times slower than transition C. This is to be expected since the first and last symbols are not overlapping with a preceding or following symbol respectively and feature the original triangular slope. Transition C occurs at twice the original triangle slope since it results from the overlap between two opposite and overlapping triangles (see Figure 8).

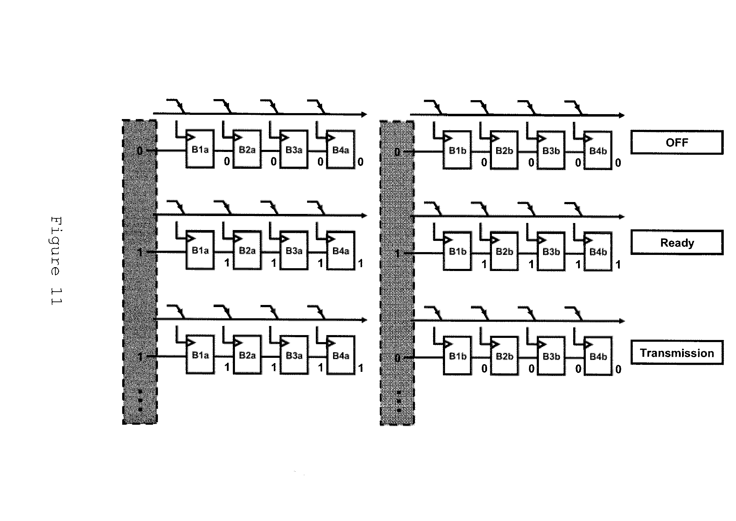

The Bik values are provided by two sets of four stages shift registers clocked by the four outputs from the divider, one for the Bia values and the other for the Bib values. Before applying the code sequence, all four registers are reset to zero. Then the value "1" is first applied to both registers such that by propagating along the shift registers, they will progressively start-up the modulator. The real code (opposite value at both inputs) can than be applied to start the burst. This sequence of operations is depicted in Figure 11.

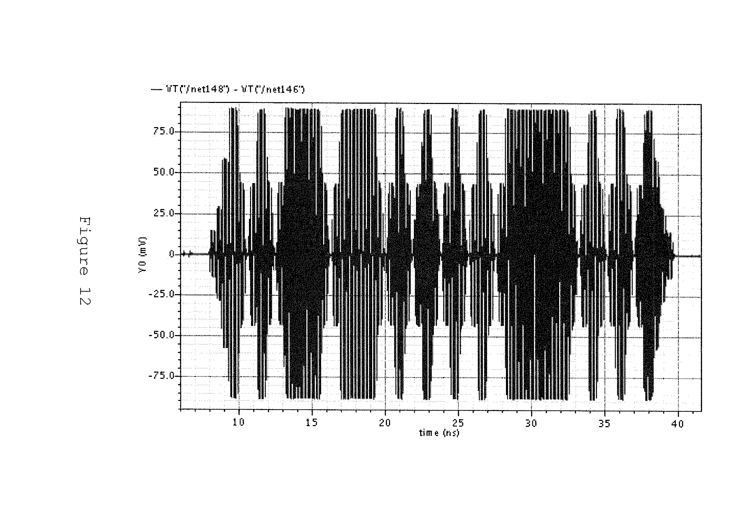

A simulated output of the modulator is shown in Figure 12. Such simulation can be realized with the cell "Total_simulation". The modulator feeds directly a 500hm antenna. The output voltage is larger than 90mV peak.

To produce a burst of BPSK modulated chips, the RF LO must be modulated by a code sequence of +1 and -1 predefined by the standard for each piconet. The modulation operation is achieved by inverting and shaping the carrier at each code transition. A nice feature of the synchronous divider is the fact that the timing required to shape the pulses is available in the intermediate phases, as shown in Figure 8. Four discrete steps are taken to invert the carrier by using four parallel multipliers that are consecutively activated by four properly chosen phases of the divider HTL chain. Each multiplier multiplies the RF LO with the code value (+1 -1). Thereby, a code transition produces at the sum output an RF LO inversion in four discrete steps as a result of the sequential activation of the multipliers.

**Claims**

1. A device for generating an output signal at least part of which is an oscillation signal with a characterising frequency and with a predefined transient at start-up, comprising

   - a variable oscillator (101) for generating said oscillation signal; and
   - a means for setting (103) initial conditions in said variable oscillator (101), to impose said predefined transient on said oscillation signal at start-up.

2. A device according to claim 1, further comprising a feedback means (104) for controlling the frequency of said oscillation signal.

3. A device according to claim 2, **characterised in that** said feedback means (104) comprises detection means (205) for comparing said characterising frequency to that of a reference and for inputting a result indicative of said comparison into storage means (102) associated with said variable oscillator (101).

4. A device according to claim 3, further comprising a dividing means (206) for dividing the frequency of said output signal at least once to a signal with a frequency roughly matching a preset frequency.

5. A device according to claim 4, **characterised in that** said detection means (205) is provided for comparing said divided frequency to that of a reference and for inputting a result indicative of said comparison into said storage means (102).

6. A device according to any of the previous claims, **characterised in that** said variable oscillator (101) comprises at least two cascaded stages (304, 305), said initial condition setting means (103) being connected to nodes in between said stages.

7. A device according to claim 6, **characterised in that** said nodes are voltage nodes and said initial condition setting means comprises switches (307, 308) between ground and supply voltage on said voltage nodes.

8. A device according to one of claims 1-7, further comprising a modulator (202) producing a BPSK modulated signal on the basis of said output signal.

9. A telecom device comprising said device according to claims 1-8.

10. A telecom device according to claim 9, **characterised in that** said telecom device is a transmitter.

11. A telecom device according to claim 9, **characterised in that** said telecom device is a receiver.

12. A telecom device according to claim 9, **characterised in that** said telecom device is a transceiver.

13. A telecom device according to anyone of the claims 9-12, **characterised that** said telecom device is an ultra-wide bandwidth telecom device.

14. A method for generating an output signal, at least part of which is an oscillation signal with a predefined transient at start-up, the method comprising the steps of:

   a) providing initial conditions determining said predefined transient in initial condition setting means (103);
   b) imposing said initial conditions on a variable oscillator (101); and
   c) starting said variable oscillator (101) to generate said oscillation signal.

15. A method according to claim 14, further comprising the step of reading out stored characterising frequency simultaneously with step b.

16. The method according to claim 14 or 15, further comprising the step of controlling the frequency of said oscillation signal by means of a feedback means (104).

17. The method according to claim 16, **characterised in that** the step of controlling the frequency comprises the step of comparing said frequency of said oscillation signal to that of a reference, and inputting a result indicative of said comparison into said storage means (102).

18. The method according to one of claims 14-17, further comprising the step of dividing the frequency of said output signal at least once to a signal with a frequency roughly matching a preset frequency.

19. The method according to one of claims 14-18, **characterised in that** the step of imposing said initial conditions on said variable oscillator comprises the step of imposing said initial conditions on nodes in between cascaded stages (304, 305, 306) of said variable oscillator.

20. The method according to claim 19, **characterised in that** the step of imposing said initial conditions on said nodes comprises the step of switching said nodes to either ground or supply voltage.

21. A method according to claim 14-20, further comprising the step of modulating said oscillation signal to a BPSK modulated signal.

22. A method for low power operation of a telecom device according to anyone of the claims 9-13 **characterised that** the method comprises the steps of:

   a) partly powering-on said telecom device;
   b) providing initial conditions determining a predefined transient in the initial condition setting means;
   c) imposing said initial conditions on said variable oscillator (101);
   d) powering-down said telecom device; and
   e) storing a latest frequency of said oscillation signal generated by said device in said storage means (102).

Figure 1

Figure 2

Figure 3

Figure 4

Figure 5

Figure 6

Figure 7

Figure 8

Figure 9

Figure 10

Figure 11

Figure 12

**European Patent
Office**

**PARTIAL EUROPEAN SEARCH REPORT**

which under Rule 45 of the European Patent Convention
shall be considered, for the purposes of subsequent
proceedings, as the European search report

Application Number

EP 07 10 6731

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 252 467 B1 (YOSHIMURA TSUTOMU [JP]) 26 June 2001 (2001-06-26) * column 3, line 62 - column 10, line 21 * ----- | 1-21 | INV. H03L7/00 |
| X,D | EP 0 601 780 A2 (AMERICAN TELEPHONE & TELEGRAPH [US] AT & T CORP [US]) 15 June 1994 (1994-06-15) * column 2, line 21 - column 4, line 54 * ----- | 3-13, 17-21 | |
| P,X | US 7 132 903 B1 (JOHNSON PHILLIP [US] ET AL) 7 November 2006 (2006-11-07) * column 3, line 1 - column 4, line 45 * ----- | 1-21 | |
| P,X | US 2006/244543 A1 (MELTZER DAVID [US]) 2 November 2006 (2006-11-02) * paragraph [0026] - paragraph [0041] * ----- | 1-21 | |
| A | WO 2006/094985 A (TEXAS INSTRUMENTS DEUTSCHLAND [DE]; ROMBACH GERD [DE]; DIETEL MARKUS []) 14 September 2006 (2006-09-14) * page 3, line 1 - line 31 * ----- | 1-21 | |

-/--

TECHNICAL FIELDS
SEARCHED (IPC)

H03L

## INCOMPLETE SEARCH

The Search Division considers that the present application, or one or more of its claims, does/do not comply with the EPC to such an extent that a meaningful search into the state of the art cannot be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| Munich | 3 July 2007 | VILLAFUERTE ABREGO |

EPO FORM 1503 03.82 (P04C07)

**European Patent** **PARTIAL EUROPEAN SEARCH REPORT** Application Number

**Office** EP 07 10 6731

| DOCUMENTS CONSIDERED TO BE RELEVANT | | | CLASSIFICATION OF THE APPLICATION (IPC) |
|---|---|---|---|
| Category | Citation of document with indication, where appropriate, of relevant passages | Relevant to claim | |
| A | US 5 136 260 A (YOUSEFI-ELEZEI NARIMAN [US]) 4 August 1992 (1992-08-04) * column 5, line 48 - column 8, line 65 * ----- | 1-21 | |
| | | | TECHNICAL FIELDS SEARCHED (IPC) |

EPO FORM 1503 03.82 (P04C10)

**European Patent**
**Office**

**INCOMPLETE SEARCH**
**SHEET C**

Application Number

EP 07 10 6731

```
Claim(s) searched completely:
        1-21

Claim(s) not searched:
        22

Reason for the limitation of the search:

The wording defining the following method steps:
a) "partly powering-on a telecom device"
d) "powering-down said telecom device"
e) "storing a latest frequency..."
are so unclear that no meaningful search is possible.
Step a) is itself unclear and, moreover,
Step d) renders stepc e) devoid of meaning.
```

## ANNEX TO THE EUROPEAN SEARCH REPORT
## ON EUROPEAN PATENT APPLICATION NO.

EP 07 10 6731

This annex lists the patent family members relating to the patent documents cited in the above-mentioned European search report.
The members are as contained in the European Patent Office EDP file on
The European Patent Office is in no way liable for these particulars which are merely given for the purpose of information.

03-07-2007

| Patent document cited in search report | | Publication date | Patent family member(s) | | Publication date |
|---|---|---|---|---|---|
| US 6252467 | B1 | 26-06-2001 | JP 2000244285 A | | 08-09-2000 |
| EP 0601780 | A2 | 15-06-1994 | DE 69324451 D1 | | 20-05-1999 |
| | | | DE 69324451 T2 | | 26-08-1999 |
| | | | JP 2912148 B2 | | 28-06-1999 |
| | | | JP 7074623 A | | 17-03-1995 |
| | | | US 5416446 A | | 16-05-1995 |
| US 7132903 | B1 | 07-11-2006 | NONE | | |
| US 2006244543 | A1 | 02-11-2006 | JP 2006311561 A | | 09-11-2006 |
| WO 2006094985 | A | 14-09-2006 | NONE | | |
| US 5136260 | A | 04-08-1992 | NONE | | |

EPO FORM P0459

For more details about this annex : see Official Journal of the European Patent Office, No. 12/82

## REFERENCES CITED IN THE DESCRIPTION

**Patent documents cited in the description**

- EP 0601780 A

**Non-patent literature cited in the description**

- **J. YUAN ; C. SVENSSON.** Fast CMOS nonbinary divider and counter. *IEE Electronic Letters,* June 1993, vol. 29 (13), 1222-1223